# EUROPÄISCHE PATENTANMELDUNG

(11) **EP 0 989 773 A2**
(43) Veröffentlichungstag der Anmeldung: **29.03.2000**
(21) Anmeldenummer: 99118504.2
(22) Anmeldetag: 18.09.1999
(51) Int. Cl.: H04R 3/00

(54) **Vorrichtung zur Schallwandlung**

(30) Priorität: 24.09.1998 DE 19843731
(71) Anmelder: Sennheiser electronic GmbH & Co. KG, 30900 Wedemark (DE)
(72) Erfinder: Marten, Stefan, Dipl.-Ing., 30900 Wedemark (DE)
(74) Vertreter: Eisenführ, Speiser & Partner

(57) **Zusammenfassung**

Beschrieben wird eine Vorrichtung zur Schallwandlung mit einem Schallwandler (3) und einer Leiterplatte (7) zum Tragen von elektrischen Bauteilen (27) und Kontaktierungen. Das Besondere der Erfindung besteht darin, daß die Leiterplatte (7) ein akustisches Bauelement zur Beeinflussung der akustischen Eigenschaften des Schallwandlers (3) bildet.

## Beschreibung

Die Erfindung betrifft eine Vorrichtung zur Schallwandlung mit einem Schallwandler und einer Leiterplatte zum Tragen von elektrischen Bauteilen und Kontaktierungen.

Es sind derartige Vorrichtungen bekannt, bei welchen ein Schallwandler, z.B. ein Mikrofon oder ein Wiedergabewandler (Lautsprecher), zur Ansteuerung eine elektronische Schaltung benötigt, welche auf einer Leiterplatte montiert einen Teil der Vorrichtung bildet.

Eine erste Gruppe derartiger Vorrichtungen bilden schnurlose Kopfhörer, bei weichen insbesondere eine HF- oder Infrarot-Empfangseinrichtung sowie eine Verstärkereinrichtung in unmittelbarer Nähe zum Wiedergabewandler angeordnet sind. Bei Kopfhörern zur aktiven Schalldämmung wird ebenfalls ein Wiedergabewandler sowie ein Sensormikrofon sowie ein Sensormikrofon und eine Ansteuerelektronik zur Regelung eines wiederzugebenden Schallsignals benötigt. Auch in diesem Fall wird versucht, die Ansteuerelektronik zusammen mit dem Schallwandler in dem Kopfhörer zur aktiven Schalldämmung unterzubringen.

Eine zweite Gruppe derartiger Vorrichtungen wird von drahtlosen Mikrofonen gebildet, bei welchen ein Schallwandler, in diesem Fall ein Mikrofon, insbesondere mit einer Mikrofonverstärkereinrichtung und einer HF- oder Infrarot-Sendeeinrichtung kombiniert ist.

Bei den bekannten Vorrichtungen werden die akustischen Eigenschaften des Wiedergabewandlers oder des Mikrofons beispielsweise durch deren Bauform oder ein entsprechend gestaltetes Gehäuse, in welchem der Schallwandler angeordnet ist, gezielt beeinflußt. Durch eine entsprechende Gehäuseform kann bei einem Mikrofon oder einem Wiedergabewandler beispielsweise dessen Richtwirkung und dessen Übertragungsbereich vorgegeben bzw. beeinflußt werden.

Neben der Übertragungsqualität werden bei derartigen Vorrichtungen zur Schallwandlung in erster Linie geringe Abmessungen und ein niedriges Gewicht gefordert. Dies stellt insbesondere deshalb eine schwierig zu erfüllende Anforderung dar, weil neben dem akustisch abgestimmten Schallwandler die Ansteuerelektronik und notwendige Kontaktierungen zwischen dem Schallwandler und der Ansteuerelektronik untergebracht werden müssen. Daneben läßt sich die Montage, bei welcher häufig feine Drahtkontaktierungen vom Schallwandler zur Ansteuerelektronik gelegt werden müssen, nur auf sehr komplizierte Weise automatisieren. Dieser zusätzliche Montageaufwand erhöht ungünstigerweise Produktionszeit und -kosten.

Aufgabe der vorliegenden Erfindung ist es daher, eine leicht zu montierende Vorrichtung zur Schallwandlung bereitzustellen, welche einen vergleichsweise einfachen Aufbau aufweist.

Die Aufgabe wird bei der Vorrichtung der eingangs genannten Art erfindungsgemäß dadurch gelöst, daß die Leiterplatte ein akustisches Bauelement zur Beeinflussung der akustischen Eigenschaften des Schallwandlers bildet.

Die Vorteile der Erfindung liegen insbesondere darin, daß zusätzliche zur Beeinflussung der Richtwirkung und/oder des Übertragungsbereichs eines Schallwandlers notwendige Gehäuseteile eingespart und somit eine wesentliche Verringerung der Baugröße der Vorrichtung erzielt wird. Des weiteren wird eine schnellere und preiswertere Montage der Vorrichtung erreicht, weil nach Zusammenfügen des Schallwandlers und der Ansteuerelektronik elektrische und akustische Bauelemente der Vorrichtung als ein einziges handhabbares Teil vorliegten. Somit ist bereits zu einem sehr frühen Zeitpunkt im Montageablauf eine Prüfung der akustischen und elektronischen Bauteile der Vorrichtung möglich, bevor eine endgültige Montage, beispielsweise in einem Kopfhörer, vorgenommen wird.

Bei einer bevorzugten Ausführungsform der Vorrichtung, bei welcher der Schallwandler eine Schallöffnung zur Aufnahme oder Abgabe von Schallwellen aufweist, ist die Leiterplatte vor der Schallöffnung des Schallwandlers angeordnet und ein entsprechender, die Schallöffnung abdeckender Leiterplattenabschnitt weist mindestens eine Durchbrechung auf. Eine Aufnahme oder Abgabe von Schallwellen erfolgt somit durch die in dem entsprechenden Leiterplattenabschnitt vorgesehenen Durchbrechung. Bei einer zweckmäßigen Weiterbildung sind mehrere Durchbrechungen in dem entsprechenden Leiterplattenabschnitt vorgesehen.

Die akustischen Eigenschaften des Schallwandlers lassen sich insbesondere durch Verändern der Querschnittsfläche der Durchbrechungen, der Dicke der Leiterplatte und des Volumens zwischen Leiterplatte und Schallwandler beeinflussen. Besonders vorteilhaft ist die Vorrichtung derart gestaltet, daß der die Schallöffnung abdeckende und mindestens eine Durchbrechung aufweisende Leiterplattenabschnitt zusammen mit dem zwischen dem Schallwandler und dem Leiterplattenabschnitt gebildeten Hohlraum einen Resonator bildet. Durch eine entsprechende Abstimmung der Resonanzfrequenz des Resonators läßt sich gezielt das Übertragungs- und das Phasenverhalten der Vorrichtung zur Schallwandlung vorgeben.

Bei einer zweckmäßigen Weiterbildung der Vorrichtung ist die Durchbrechung mit einem akustisch dämpfenden Material abgedeckt. Das akustisch dämpfende Material kann beispielsweise Seide oder ein Vlies sein und ist zweckmäßigerweise auf die dem Schallwandler abgewandte Oberfläche der Leiterplatte aufgeklebt. Es ist jedoch ebenfalls möglich, das akustisch dämpfende Material über die Durchbrechung zu spannen oder zwischen der Leiterplatte und einem umgebenden Gehäuse einzuklemmen.

Die akustischen Eigenschaften lassen sich durch das vor der Durchbrechung angeordnete akustisch dämpfende Material weiter beeinflussen. So ist es beispielsweise möglich, Resonanzspitzen des durch den Schallwandler und die Leiterplatte gebildeten Resonators gezielt zu bedämpfen. Außerdem läßt sich durch geeignetes akustisch dämpfendes Material ebenfalls Einfluß auf den Frequenzverlauf der Vorrichtung nehmen.

Bei einer bevorzugten Ausführungsform ist in Verlängerung an die Durchbrechung ein Schallkanal angeordnet. Durch Verändern der Länge des Schallkanals läßt sich vorteilhafterweise die Resonanzfrequenz des zwischen dem Schallwandler und der Leiterplatte gebildeten Resonators in einem größeren Bereich abstimmen. Bei einer zweckmäßigen Weiterbildung weist der Schallkanal eine nach außen größer werdende Querschnittsfläche auf, durch welche insbesondere die Richtcharakteristik des Schallwandlers vorgegeben werden kann.

Besonders bevorzugt ist der Schallwandler mechanisch, insbesondere form- oder kraftschlüssig, mit der Leiterplatte verbunden. Der Schallwandler kann dabei an die Leiterplatte geschweißt, geklebt oder geschraubt sein. Alternativ ist es möglich, daß ein am Schallwandler vorgesehenes Arretierungselement durch eine entsprechende Durchbrechung in der Leiterplatte hindurchgreift und ein Widerlager bildet, so daß der Schallwandler mittels einer Schnappverbindung mit der Leiterplatte verbunden ist.

Besonders vorteilhaft besteht zwischen dem Schallwandler und der Leiterplatte eine luftdichte Verbindung, um zu gewährleisten, daß zwischen dem Schallwandler und der Leiterplatte keine Schallenergie unkontrolliert austritt. Dazu kann entweder an dem Schallwandler oder an der Leiterplatte ein entsprechendes Dichtungsmaterial vorgesehen sein, oder der Schallwandler wird mit der Leiterplatte verschweißt oder verklebt.

Der Schallwandler ist bei einer weiteren bevorzugten Ausführungsform insbesondere durch eine Löt- oder Steckverbindung mit Kontaktierungen der Leiterplatte verbunden. Derartige Kontaktierungen vereinfachen die Montage des Schallwandlers auf der Leiterplatte, da mit einer mechanischen Kopplung gleichzeitig eine elektrische Verbindung realisiert werden kann.

Bei dem in der Vorrichtung vorgesehenen Schallwandler kann es sich entweder um einen Wiedergabewandler oder um ein Mikrofon handeln. Es ist natürlich ebenfalls möglich, auf einer Leiterplatte sowohl einen Wiedergabewandler als auch ein Mikrofon auf erfindungsgemäße Weise anzubringen.

Vorteilhafte Weiterbildungen der Erfindung sind durch die Merkmale der Unteransprüche gekennzeichnet. Im folgenden wird die Erfindung anhand der Zeichnung beispielhaft erläutert.

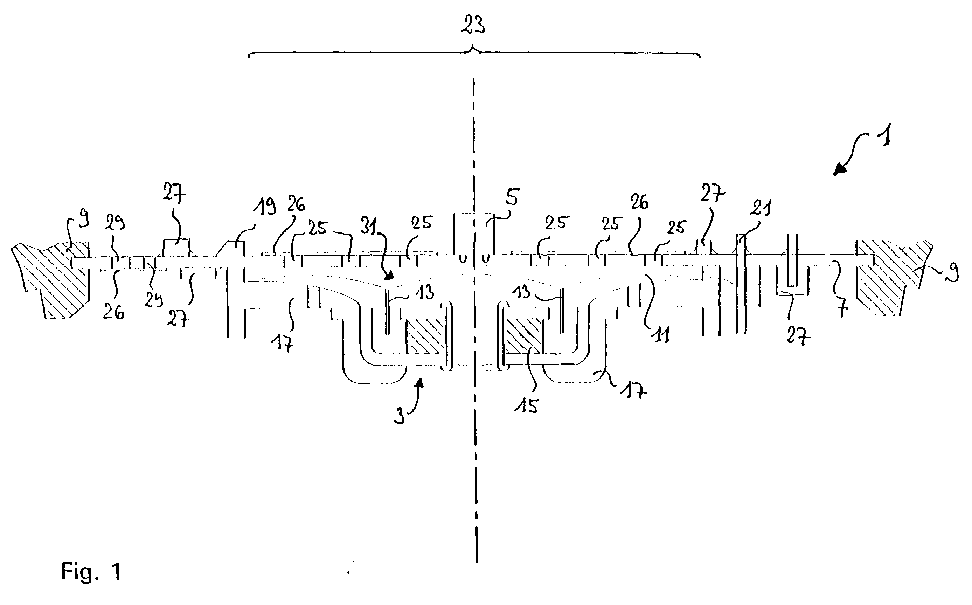

- Figur 1: zeigt einen Querschnitt durch eine erfindungsgemäße Vorrichtung zur Schallwandlung.

Figur 1 zeigt einen Querschnitt durch einen Abschnitt eines Kopfhörers zur aktiven Schalldämmung. Dargestellt ist ein als Wiedergabewandler dienender Lautsprecher 3, ein Sensormikrofon 5 zum Aufnehmen von für die Regelung notwendigen Schallsignalen, eine Leiterplatte 7 und Gehäuseabschnitte 9.

Der Lautsprecher umfaßt eine Membran 11, welche mit einer Schwingspule 13 verbunden ist, einen Magneten 15 mit einem Luftspalt, in welchem die Schwingspule 13 zumindest teilweise angeordnet ist, und ein Wandlergehäuse 17, welches die Membran 11 und den Magneten 15 trägt. Das Wandlergehäuse 17 umfaßt ferner einen Arretierungsfortsatz 19 und eine Wandlerkontaktierung 21. Der Arretierungsfortsatz 19 ist derart gestaltet, daß dieser durch eine entsprechende Durchbrechung in der Leiterplatte 17 hindurchragt und mit der Leiterplatte 7 ein Widerlager bildet. Die Wandlerkontaktierung 21 ist zum einen mit der Schwingspule 13 und zum anderen mit einer entsprechenden Kontaktierung auf der Leiterplatte 7 elektrisch verbunden.

Die Leiterplatte 7 ist beiderseits an Gehäuseabschnitten 9 befestigt, indem sie in der dargestellten Ausführung in die entsprechenden Gehäuseabschnitte 9 eingreift. Die Befestigung kann beispielsweise aber auch durch Verschrauben oder Verkleben erfolgen. Der Lautsprecher 3 ist mit seiner Schallöffnung zur Abgabe von Schallwellen unmittelbar an einer Oberfläche der Leiterplatte 7 angeordnet und dort mit Hilfe von Arretierungsfortsätzen 19 befestigt. Die Arretierungsfortsätze 19 können beispielsweise in die Leiterplatte geklemmt oder an dieser verklebt sein. Mit Kontakten 21 ist der Lautsprecher 3 an der Leiterplatte 7 angeschlossen, wobei die Kontakte 21 zusätzlich als Befestigungselemente dienen können. In dem die Schallöffnung des Lautsprechers 3 abdeckenden Leiterplattenabschnitt 23 sind erste Durchbrechungen 25 zur Beeinflussung der akustischen Eigenschaften des Lautsprechers 3 angeordnet. Auf der dem Lautsprecher 3 gegenüberliegenden oder zugewandten Seite der Leiterplatte 7 ist ein akustisch dämpfendes Material 26, beispielsweise aus Seide oder Vlies, befestigt, so daß die ersten Durchbrechungen 25 abgedeckt sind; diese Durchbrechungen 25 können zumindest zum Teil aber auch freiliegen.

Zentral auf dem Leiterplattenabschnitt 23 ist das Sensormikrofon 5 angeordnet. Im Randbereich des Leiterplattenabschnittes 23 und auf den übrigen Abschnitten der Leiterplatte 7 sind elektrische Bauteile 27 vorgesehen. Ferner weist die Leiterplatte 7 zweite Durchbrechungen 29 auf, welche ebenfalls durch ein akustisch dämpfendes Material 26 zumindest teilweise abgedeckt sein können.

Der die Schallöffnung abdeckende und die ersten Durchbrechungen 25 aufweisende Leiterplattenabschnitt 23 bildet zusammen mit dem zwischen der Membran 11 des Lautsprechers 3 und dem Leiterplattenabschnitt 23 gebildeten Hohlraum 31 einen Resonator. Das akustische Verhalten des Resonators läßt sich dabei im wesentlichen durch Verändern der Größe des Hohlraums 31, der Querschnittsfläche der ersten Durchbrechungen 25 und der Dicke der Leiterplatte 7 beeinflussen. Darüber hinaus ist eine weitere Abstimmung der akustischen Eigenschaften durch das akustisch dämpfende Material 26, welches vor den ersten Durchbrechungen 25 angeordnet ist, möglich.

## Patentansprüche

1. Vorrichtung (1) zur Schallwandlung mit
einem Schallwandler (3) und
einer Leiterplatte (7) zum Tragen von elektrischen Bauteilen (27) und Kontaktierungen,
dadurch gekennzeichnet, daß die Leiterplatte (7) ein akustisches Bauelement zur Beeinflussung der akustischen Eigenschaften des Schallwandlers (3) bildet.

2. Vorrichtung nach Anspruch 1, bei welcher der Schallwandler eine Schallöffnung zur Aufnahme oder Abgabe von Schallwellen aufweist,
dadurch gekennzeichnet, daß die Leiterplatte (7) vor der Schallöffnung des Schallwandlers (3) angeordnet ist und
ein entsprechender, die Schallöffnung abdeckender Leiterplattenabschnitt (23) mindestens eine Durchbrechung aufweist.

3. Vorrichtung nach Anspruch 2,
derart gestaltet, daß der die Schallöffnung abdeckende und eine Durchbrechung aufweisende Leiterplattenabschnitt (23) zusammen mit dem zwischen dem Schallwandler (3) und dem Leiterplattenabschnitt (23) gebildeten Hohlraum (31) einen Resonator bildet.

4. Vorrichtung nach Anspruch 2 oder 3,
dadurch gekennzeichnet, daß die Durchbrechung mit einem akustisch dämpfenden Material (26) abgedeckt ist.

5. Vorrichtung nach einem der Ansprüche 2 bis 4,
dadurch gekennzeichnet, daß in Verlängerung an die Durchbrechung ein Schallkanal angeordnet ist.

6. Vorrichtung nach Anspruch 5,
dadurch gekennzeichnet, daß sich die Querschnittsfläche des Schallkanals in dessen Längsrichtung ändert.

7. Vorrichtung nach Anspruch 6,
dadurch gekennzeichnet, daß sich die Querschnittsfläche des Schallkanals zu dessen offenem Ende hin vergrößert.

8. Vorrichtung nach einem der vorstehenden Ansprüche,
dadurch gekennzeichnet daß der Schallwandler (3) ein Arretierungselement (19) aufweist, welches den Schallwandler (3) mechanisch, insbesondere formschlüssig, mit der Leiterplatte (7) verbindet.

9. Vorrichtung nach einem der Ansprüche 1 bis 7,
dadurch gekennzeichnet, daß der Schallwandler (3) mechanisch, insbesondere kraftschlüssig, mit der Leiterplatte (7) verbunden ist.

10. Vorrichtung nach einem der vorstehenden Ansprüche,
dadurch gekennzeichnet, daß zwischen dem Schallwandler (3) und der Leiterplatte (7) eine im wesentlichen luftdichte Verbindung besteht.

11. Vorrichtung nach einem der vorstehenden Ansprüche,
dadurch gekennzeichnet, daß der Schallwandler (3) elektrisch mit den Kontaktierungen der Leiterplatte (7) verbunden ist.

12. Vorrichtung nach einem der vorstehenden Ansprüche,
dadurch gekennzeichnet, daß der Schallwandler (3) durch einen Wiedergabewandler gebildet wird.

13. Vorrichtung nach einem der Ansprüche 1 bis 11,
dadurch gekennzeichnet, daß der Schallwandler (3) durch ein Mikrofon oder eine Mikrofonkapsel gebildet wird.

14. Mikrofon mit einer Vorrichtung (1) zur Schallwandlung nach Anspruch 13.

15. Kopfhörer mit einer Vorrichtung (1) zur Schallwandlung nach einem der vorstehenden Ansprüche.
